# EUROPÄISCHE PATENTSCHRIFT

(11) **EP 0 490 266 B1**
(45) Veröffentlichungstag und Bekanntmachung des Hinweises auf die Patenterteilung: **25.06.1997**
(21) Anmeldenummer: 91120876.7
(22) Anmeldetag: 05.12.1991
(51) Int. Cl.: H03K 17/95, G01V 3/08

(54) **Annäherungsschalter**
Proximity switch
Commutateur de proximité

(30) Priorität: 05.12.1990 DE 4038820
(43) Veröffentlichungstag der Anmeldung: 17.06.1992
(73) Patentinhaber: Kluge, Reinhold, D-85399 Hallbergmoos (DE)
(72) Erfinder: Kluge, Reinhold, D-85399 Hallbergmoos (DE)
(74) Vertreter: Gustorf, Gerhard, Dipl.-Ing.

(56) Entgegenhaltungen:
- EP-A- 0 179 384
- EP-A- 0 283 291
- DE-A- 2 931 412
- US-A- 4 182 985
- US-A- 5 045 920

## Beschreibung

Die Erfindung betrifft einen Annäherungsschalter nach dem Oberbegriff des Patentanspruchs 1.

Derartige Annäherungsschalter arbeiten in der Regel mit einem Sensor, der nach dem Hall-Effekt wirkt, und dienen dazu, beim Vorbeilauf unterschiedlich geformter, rotierender Körper die Drehzahl bzw. den Drehwinkel zu bestimmen. Ein Beispiel hierfür findet sich in der DE-A 40 08 141 und ist dort in Anwendung auf einen Winkelsensor zum Detektieren des Kurbelwellenwinkels für die Zündzeitpunktsteuerung eines Verbrennungsmotors beschrieben. Das zu detektierende Teil besitzt die Form eines Zahnrades und in der Regel einen bizarr geformten Rand, der bei dem Vorbeilauf an dem Magnetfeldsensor einen starken Signalausschlag liefert.

Da analoge Magnetfeldsensoren grundsätzlich eine starke Temperaturabhängigkeit in ihrem Ausgangssignal besitzen, ergeben sich dann Probleme, wenn das zu detektierende Teil nicht mehr eine stark veränderliche Wirkfläche besitzt und damit keine großen, sich ständig ändernden Felder für den Magnetfeldsensor bewirken kann. Dann tritt der Fall ein, daß die Änderung des Ausgangssignals bei Annäherung des zu detektierenden Teils in der Größenordnung der thermischen Änderung des Ausgangssignals liegt.

Gegegenstand der DE-A 29 31 412 ist ein Sensor zur Messung magnetisch leitender Verunreinigungen, beispielsweise zum Erkennen von Metallabrieb in einem Ölbad. Der Sensor ist in einem zylindrischen Gehäuse untergebracht, dessen freie Stirnfläche so ausgebildet ist, daß nur eine von zwei Feldplatten der Beeinflussung durch die zu detektierende Metallspäne ausgesetzt ist. Die beiden Feldplatten bilden den Zweig einer Brückenschaltung, dessen anderer Zweig zwei Widerstände hat. Das Ausgangssignal des Sensors kann entweder analog dargestellt oder über eine Schwellwert-Logik geführt werden, so daß bei Überschreiten eines vorgegebenen Wertes eine Anzeige erfolgt, die auf das Vorhandensein einer bestimmten Menge angesammelten Metallabriebs hinweist.

Ein Näherungsschalter der im Oberbegriff des Anspruchs 1 angegebenen Bauart ist aus der EP-A 283 291 bekannt. Dabei handelt es sich um einen als Zahnradsensor ausgebildeten Drehzahlsensor, der ein zylindrisches Gehäuse hat. Solche Sensoren werden an Stellen eingebaut, wo viel Platz vorhanden ist, so daß keine Notwendigkeit besteht, das Gehäuse möglichst klein auszuführen. Bei großvolumigen Gehäusen sind jedoch die Einflüsse durch ein ferromagnetisches Umfeld vernachlässigbar klein. Hinzu kommt, daß bei derartigen Zahnradsensoren keine Vorzugslage des Näherungsschalters erforderlich ist, weil immer nur zwei Meßstellungen möglich sind, bei denen dem einen Hallsensor ein Zahn und dem anderen Hallsensor eine Lücke gegenüberliegt. Ferner kommt hinzu, daß die rotationssymmetrischen Gehäuse dieser Näherungsschalter nur mit ihrer flachen Bodenseite auf einer Montagefläche angebracht werden können, da eine Montage über die zylindrische Seitenfläche nicht möglich ist. Sofern die Montagefläche am Boden des Magneten allerdings aus einem ferromagnetischen Werkstoff besteht, würde die gewünschte Funktion als Drehzahlsensor gestört, weil die an der Oberseite austretenden Feldlinien zu der ferromagnetischen Montagefläche nach unten hin abgelenkt würden, so daß die beiden oben angebrachten Hall-Elemente von dem Magnetfeld nicht mehr ausreichend angesteuert werden können.

Der Erfindung liegt die Aufgabe zugrunde, einen Annäherungsschalter in Kleinstbauweise zur Verfügung zu stellen, der auch bei sehr beengten Platzverhältnissen funktionssicher eingebaut werden kann, beispielsweise im Türschloßbereich von Kraftfahrzeugen, wo Stahlteile auch als Montagefläche dienen. Dabei soll mit einfachen Mitteln eine Vorspannung bei der Schaltwirkung erreicht werden, so daß der Schalter auf geringe Feldänderungen bei der Annäherung eines ferromagnetischen Teils ohne thermische Beeinflussung sicher reagiert.

Gemäß der Erfindung wird diese Aufgabe durch die im Anspruch 1 angegebenen Kennzeichen gelöst. Vorteilhafte Ausgestaltungen ergeben sich aus den abhängigen Ansprüchen.

Die Ausbildung des Gehäuses mit ebenen Montageflächen erlaubt einen Einbau auch bei sehr beengten Platzverhältnissen. Ein weiterer Vorteil besteht darin, daß eine stapelbare Montage von zwei oder mehr Schaltern möglich ist, wobei bei Bedarf ferromagnetische Trennbleche dazwischengelegt werden können.

Durch die versetzte Lage der Achsen wird mit gegenüber dem Stand der Technik wesentlich einfacheren Mitteln eine Unsymmetrie für die Vorzugslage des Schalters erreicht, so daß die Annäherung eines ferromagnetischen Teils aufgrund der durch die außermittige Montage erzeugten Vorspannung frühzeitig und sicher erkannt werden kann.

Durch die Differenzschaltung der beiden Magnetfeldsensoren werden thermische Einflüsse unwirksam gemacht. Dabei wird die Annahme zugrundegelegt, daß sich diese Einflüsse in aller Regel auf beide Magnetfeldsensoren in zumindest ähnlicher Weise auswirken. Durch die Beaufschlagung mit dem Grund-Magnetfeld wird zudem eine Sicherheit gegenüber Einflüssen erzielt, die sich beim jeweiligen Anwendungsfall aus der Präsenz ohnehin vorhandener, nicht zu detektierender Metallteile, beispielsweise innerhalb des Gehäuses, ergeben. Es wird dabei angenommen, daß sich diese Einflüsse in einer Größenordnung des Magnetfelds bewegen, die wesentlich kleiner als die des Grund-Magnetfeldes sind.

Aber auch, wenn diese Größenordnung erreicht wird, beispielsweise bei Montage des Gehäuses auf oder zwischen ferromagnetischen Halteteilen, bleibt die Funktionsfähigkeit erhalten, sofern sich die Störeinflüsse für beide Magnetfeldsensoren zumindest annähernd ausgleichen.

Das Wirkungsprinzip des Annäherungsschalters besteht darin, daß bei Annäherung eines ferromagnetischen Metallteils die beiden Magnetfeldsensoren in aller Regel mit einem geringfügig unterschiedlichen Magnetfeld bzw. einer unterschiedlichen Magnetfeldänderung beaufschlagt werden. Dieser Unterschied reicht aus, um die Schaltschwelle zu überwinden und eine nachgeschaltete Auswerteschaltung ansprechen zu lassen. Entsprechend kann dann, wenn sich das ferromagnetische Metallteil wieder vom Annäherungsschalter entfernt, durch die sich dann ebenfalls ergebende, zumindest geringfügig unterschiedliche Magnetfeldbeaufschlagung der beiden Magnetfeldsensoren ein Schaltvorgang ausgelöst werden.

Durch die Anwendung eines geringfügig unterschiedlichen Grundmagnetfeldes auf die beiden Magnetfeldsensoren wird die Empfindlichkeit des Annäherungsschalters eingestellt. In aller Regel ist dann nur noch eine wesentlich kleinere Magnetfeldänderung, bedingt durch das zu detektierende Metallteil, erforderlich, um den Schalter ansprechen zu lassen.

Das Grund-Magnetfeld kann mit Hilfe jeweils eines Magneten erzeugt werden, der mit jedem der Magnetfeldsensoren zusammenwirkt. Dabei können sich jedoch Probleme hinsichtlich der Stärke der beiden Magnetfelder ergeben, da der einzuhaltende Unterschied in der Stärke dieses Magnetfelds mit zwei separaten Magneten insbesondere bei einer Großserienherstellung schwer einzuhalten ist. Demgegenüber ergibt sich eine bedeutende Vereinfachung dadurch, daß das Grund-Magnetfeld durch einen im Gehäuse angeordneten Prägemagneten geliefert wird. Die Veränderung des Magnetfelds kann sich beispielsweise bei einer symmetrischen Ausrichtung der beiden Magnetfeldsensoren gegenüber dem Prägemagneten durch Einfügen eines feldschwächenden Teiles zwischen dem Prägemagneten und dem einen Magnetfeldsensor für die beiden Sensoren unterschiedlich einstellen. Demgegenüber ergibt sich eine bedeutende Vereinfachung durch die Merkmale des Patentanspruchs 1. Durch eine einfache Änderung der Orientierung der beiden Magnatfeldsensoren gegenüber dem Prägemagneten läßt sich die gewünschte unterschiedliche Beaufschlagung der beiden Magnetfeldsensoren mit einem Grund-Magnetfeld problemlos einstellen.

Schließlich kann durch eine konstruktive Ausgestaltung des Gehäuses zusätzlich die Empfindlichkeit auf der einen Seite und die Störsicherheit auf der anderen Seite gesteigert werden. Hierzu besitzt das Gehäuse auf seiner Außenseite eine unregelmäßige Kontur, die beispielsweise eine Annäherung des zu detektierenden Metallteiles nur in einem bestimmten Bereich ermöglicht und bei dem sichergestellt ist, daß bei Annäherung innerhalb dieses Bereichs die Schaltschwelle überschritten wird. Entsprechend kann durch eine unterschiedliche Ausrichtung der beiden Magnetfeldsensoren und des für die Beaufschlagung mit dem Grundmagnetfeld verantwortlichen Magneten dieses Ziel erreicht werden. Hierzu kann beispielsweise der Abstand der beiden Magnetfeldsensoren von der Außenseite des beispielsweise regelmäßig geformten Gehäuses unterschiedlich sein.

In der Zeichnung ist ein Ausführungsbeispiel der Erfindung dargestellt. Es zeigen:
Figur 1 einen erfindungsgemäßen Annäherungsschalter in der Draufsicht,
Figur 2 den Schalter der Figur 1 in einer Vorderansicht und
Figur 3 den Schalter nach Figur 2 mit Montagefläche.

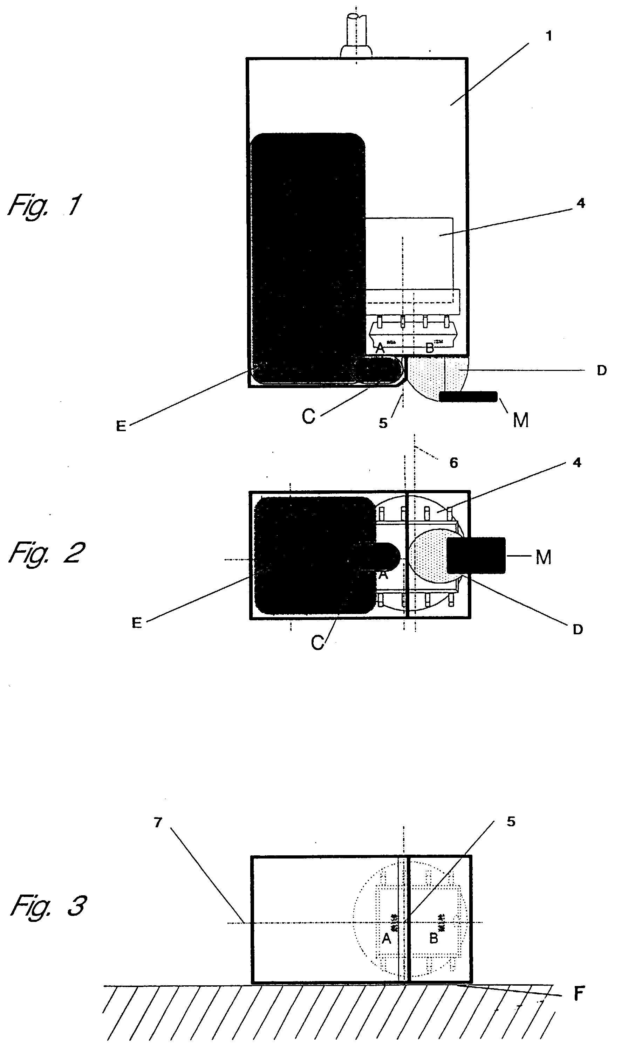

Beim Ausführungsbeispiel der Figuren 1 und 2 besitzt ein dargestellter Annäherungsschalter ein etwa quaderförmiges Gehäuse 1, in dem zwei analoge Magnetfeldsensoren A und B angeordnet sind. Die Sensoren A und B sind als kleine Blättchen dargestellt und arbeiten nach dem Hall-Effekt. Sie liefern ein analoges Spannungs-Ausgangssignal, das im unmittelbaren Zusammenhang mit der Stärke eines einwirkenden Magnetfeldes steht.

Dieses Magnetfeld wird einerseits mit Hilfe eines Prägemagneten 4 erzeugt, der ein Magnetfeld mit einer Ausrichtung erzeugt, dessen Achse 5 parallel versetzt zur Mittelachse 6 der beiden Magnetfeldsensoren A und B verläuft. Die beiden Magnetfeldsensoren A und B werden somit mit einem Magnetfeld beaufschlagt, das bedingt durch den Versatz der beiden Achsen 5 und 6 unterschiedlich ist. Der Unterschied ist etwa so gewählt, daß die Ausgangssignale der beiden Magnetfeldsensoren A und B um einen Wert verschieden sind, der in etwa gleich dem Wert der Schaltschwelle ist. Die Schaltschwelle wiederum ergibt sich innerhalb einer nicht dargestellten Differenzschaltung, der die Ausgangssignale der beiden Magnetfeldsensoren A und B zugeführt werden und der ein ebenfalls nicht dargestellter Komparator mit einem Schwellwert nachgeschaltet ist, der im Bereich der Schaltschwelle liegt.

Mit Hilfe des dargestellten Annäherungsschalters ist es möglich, ein angedeutetes, ferromagnetisches Metallteil M, beispielsweise eine Kraftfahrzeugtür, zu detektieren, sofern es sich in einem Bereich in der Nähe des Gehäuses 1 befindet, der in den Figuren 1 und 2 mit D bezeichnet ist. Bei Annäherung des ferromagnetischen Metallteils M in diesem Bereich wird der Schwellwert der Differenzschaltung überschritten, da das Grund-Magnetfeld, das durch den Prägemagneten 4 hervorgerufen wird, durch dieses Metallteil im Bereich D erhöht wird. Es spielt dabei keine Rolle, ob das ferromagnetische Metallteil beispielsweise selbst magnetisch ist oder lediglich unter dem Einfluß des Prägemagneten 4 magnetisiert wird. In jedem Fall ist die Änderung des Ausgangssignals der beiden Magnetfeldsensoren A und B bei Annäherung eines dargestellten ferromagnetischen Metallteils M in einem Nutzbereich D unterschiedlich und führt zum Überschreiten der genannten Schaltschwelle.

Zusätzlich ist in den Figuren 1 und 2 dargestellt, wie durch eine unregelmäßige Gestalt an einer Seite des quaderförmigen Gehäuses 1 eine mögliche Fehlauslösung des Annäherungsschalters verhindert wird. Mit C ist dabei eine Vergrößerung des Gehäuses 1 in dem Bereich gezeigt, in dem bei Annäherung eines ferromagnetischen Metallteils M möglicherweise eine Fehlauslösung des Annäherungsschalters erfolgt. Unter Fehlauslösung ist dabei auch der Fall zu verstehen, bei dem der Annäherungsschalter gerade nicht anspricht. Dies ist beispielsweise für den Bereich E erläutert, der sich an den Nutzbereich D anschließt. Ein Metallteil in diesem Bereich E würde die unterschiedliche Beaufschlagung der beiden Magnetfeldsensoren A und B möglicherweise verstärken und dazu führen, daß die Schaltschwelle bei der Annäherung von M nicht mehr überschritten werden kann.

Es ist ohne weiteres einsichtig, daß der dargestellte Annäherungsschalter unempfindlich gegenüber thermischen Einflüssen ist. Diese wirken sich in aller Regel auf die beiden Magnetfeldsensoren A und B in gleicher Weise aus und führen lediglich dazu, daß sich das Grund-Ausgangssignal synchron ändert, das von den beiden Sensoren erzeugt wird. Ebenfalls haben Einflüsse, die sich durch den Einbau des Gehäuses 1 an unterschiedlichen Stellen bzw. durch Anordnung ferromagnetischer Befestigungselemente außerhalb des Gehäuses ergeben, keinen Einfluß auf die Wirkungsweise des Schalters, da diese Einflüsse sich ebenfalls in zumindest annähernd gleicher Weise auf die beiden Magnetfeldsensoren A und B auswirken. Wie Figur 3 zeigt, wird dies durch mindestens eine Montagefläche erreicht, die parallel zu der Achse 7 der Magnetfeldsensoren und der Mittelachse 5 des Prägemagneten 4 verläuft. Die Einflüsse der Montagefläche F wirken sich damit auf beide Sensoren A und B in gleicher Weise aus und beeinflussen deren Funktion nicht.

## Patentansprüche

1. Annäherungsschalter für ferromagnetische Metallteile in industriellen Anlagen oder in Kraftfahrzeugen, der ein Gehäuse (1) besitzt, in dem zwei analoge Magnetfeldsensoren (A, B) angeordnet sind, deren Ausgangssignale einer Differenzschaltung mit vorgegebener Schaltschwelle zugeführt sind und die mit einem von einem Prägemagneten (4) erzeugten konstanten Grund-Magnetfeld beaufschlagt werden, dadurch gekennzeichnet, daß das Gehäuse (1) mindestens eine Montagefläche (F) besitzt, die parallel zu der gemeinsamen Achse (7) der Magnetfeldsensoren (A, B) und zur Mittelachse (5) des Prägemagneten (4) verläuft, und daß die beiden Magnetfeldsensoren (A, B) asymmetrisch gegenüber dem Prägemagneten (4) angeordnet sind, so daß die beiden Magnetfeldsensoren (A, B) mit einem etwa in der Größenordnung der Schaltschwelle unterschiedlichen Grund-Magnetfeld beaufschlagt werden.

2. Annäherungsschalter nach Anspruch 1, dadurch gekennzeichnet, daß das Gehäuse (1) auf derjenigen Außenseite unregelmäßig geformt ist, aus der die Feldlinien des Prägemagneten (4) durch eine Schaltfläche austreten und dabei denjenigen Sensor (B) durchdringen, der von einem sich nähernden Metallteil (M) zuerst erreicht wird, wodurch eine Annäherung des Metallteils (M) nur in einem Bereich (D) möglich ist, in dem die Schaltschwelle überschritten wird.

3. Annäherungsschalter nach Anspruch 1 oder 2, dadurch gekennzeichnet, daß die Magnetfeldsensoren (A, B) vor einer Polfläche des Prägemagneten (4) angeordnet sind.

## Claims

1. A proximity switch for ferromagnetic metal components in industrial installations or in motor vehicles, which has a housing (1) in which there are arranged two analog magnetic field sensors (A, B) whose output signals are supplied to a differential connection with a predetermined switching threshold and which are loaded with a constant basic magnetic field produced by a biasing magnet (4), characterised in that the housing (1) has at least one assembly surface (F) which extends parallel to the common axis (7) of the magnetic field sensors (A, B) and to the central axis (5) of the biasing magnet (4), and the two magnetic field sensors (A, B) are arranged asymmetrically in relation to the biasing magnet (4) with the result that the two magnetic field sensors (A, B) are loaded with a different basic magnetic field substantially of the order of magnitude of the switching threshold.

2. A proximity switch according to Claim 1, characterised in that the form of the housing (1) is irregular on that outer side from which the flux lines of the biasing magnet (4) emerge through a switching area and thereby penetrate that sensor (B) which is first reached by an approaching metal component (M) thus enabling approach of the metal component (M) only in a zone (D) in which the switching threshold is exceeded.

3. A proximity switch according to Claim 1 or 2, characterised in that the magnetic field sensors (A, B) are arranged in front of a pole surface of the biasing magnet (4).

## Revendications

1. Commutateur de proximité pour pièces métalliques ferromagnétiques dans les installations industrielles ou les véhicules, pourvu d'un boîtier (1) à l'intérieur duquel sont disposés deux capteurs analogiques de champ magnétique (A, B), dont les signaux de sortie sont dirigés vers une commutation différentielle à seuil de commutation prédéterminé et qui sont soumis à un champ magnétique de base constant généré par un aimant de matriçage (4), caractérisé en ce que le boîtier (1) possède au moins une face de montage (F) parallèle à l'axe commun (7) des capteurs de champ magnétique (A, B) et à l'axe médian (5) de l'aimant de matriçage (4) et que les deux capteurs de champ magnétique (A, B) sont disposés de façon asymétrique par rapport à l'aimant de matriçage (4), de sorte que les deux capteurs de champ magnétique (A, B) sont soumis à un champ magnétique de base différentiel à hauteur approximative du seuil de commutation.

2. Commutateur de proximité selon la revendication 1, caractérisé en ce que le boîtier (1) présente une forme irrégulière du côté extérieur d'où sortent les lignes de champ de l'aimant de matriçage (4) par une surface de commutation en traversant le capteur (B) atteint en premier par une pièce métallique (M) qui arrive, permettant une approche de la pièce métallique (M) uniquement dans une plage (D) où le seuil de commutation est dépassé.

3. Commutateur de proximité selon les revendications 1 ou 2, caractérisé en ce que les capteurs de champ magnétique (A, B) sont disposés devant une face polaire de l'aimant de matriçage (4).
